# EUROPEAN PATENT APPLICATION

(11) **EP 4 791 139 A1**
(43) Date of publication of application: **12.08.2026**
(21) Application number: 26155925.6
(22) Date of filing: 03.02.2026
(51) Int. Cl.: H05K 9/00

(54) **SHIELDED HOUSING DEVICE AND METHOD OF MANUFACTURING A SHIELDED HOUSING DEVICE**

(30) Priority: 07.02.2025 DK PA202530084
(71) Applicant: FalCom A/S, 2750 Ballerup (DK)
(72) Inventor: IPSEN, Klaus Sommer, Vanlose (DK)
(74) Representative: GN Store Nord A/S

(57) **Abstract**

A device housing (1) having at least a first housing part (2) and a second housing part (3), which are assembled to form an enclosure (4), so that a first abutment face (6) abuts a second abutment face (7). The first abutment face (6) is provided by an elastomeric gasket (8), which elastomeric gasket (8) is provided with protrusions (10) and a first conductive coating (9). The first housing part (2) is during assembly sled into engagement with the second housing part (3) in a first sliding direction (X) essentially parallel with the first abutment face (6), whereby the gasket (8) is squeezed in a second direction (Y) essentially perpendicular to the first direction (X) between the first abutment face (6) and the second abutment face (7). The invention is also relating to a method of manufacturing such a housing device (1).

## Description

### FIELD OF THE INVENTION

This specification relates to a device housing having at least a first housing part and a second housing part, which are adapted to be assembled to form an enclosure, so that a first abutment face of the first housing part abuts a second abutment face of the second housing part, and wherein the first abutment face is provided by an elastomeric gasket, which elastomeric gasket is provided with a first conductive coating, wherein the first housing part during assembly is sled into engagement with the second housing part in a first sliding direction essentially parallel with the first abutment face, whereby the gasket is squeezed in a second direction essentially perpendicular to the first direction between the first abutment face and the second abutment face. This specification also relates to the manufacture of such a housing device.

### BACKGROUND OF THE INVENTION

This specification relates in general to shielding of a device housing enclosing electronic components. Shielding against EMI (Electromagnetic Interference) is important and desirable for several reasons. EMI refers to the unwanted disturbance that affects an electrical circuit due to electromagnetic radiation emitted from an external source. EMI can disrupt the normal operation of electronic devices, causing them to malfunction or degrade in performance. Sources of EMI can include anything from natural phenomena like lightning to man-made sources such as motors, radios, and other electronic devices. EMC (Electromagnetic Compatibility) is the broader discipline that deals with the control of EMI. EMC ensures that electronic devices can operate in their intended environment without causing or falling victim to EMI. It involves designing and testing products to ensure they do not emit excessive electromagnetic interference and are immune to interference from other sources.

A known way of shielding a device housing is to provide the inner sides of the housing walls with a metallized layer. A good electrical connection is desired between the metallization layers of the housing parts which make up the housing. Therefore, some kind of electrical connection is provided.

Known electronic device housings requiring EMC shielding make use of a gasket of conductive material in combination with screws for assembling the housing parts. Others make use of a conduction paste in combination with screws. A third solution is combining conduction glue with screws.

US 6,965,071 (Parker-Hannifin Corporation) discloses a handheld electronic communication device with a gasket with a metallized surface.

US 2004/0071970 discloses a device housing with an upper housing wall and a lower housing wall and where a shielding gasket with a conductive coating made of tin or a tin alloy is connecting the housing walls.

US 5,847,317 (Ericsson Inc.) discloses a non-conductive elastomeric gasket where a metal plating layer covers an inside housing wall and an elastomeric gasket.

US 2014/0268583 A1 (DING) discloses device housing having at least a first housing part and a second housing part, which are adapted to be assembled to form an enclosure, so that a first abutment face of the first housing part abuts a second abutment face of the second housing part, and wherein the first abutment face is provided by an elastomeric gasket, which elastomeric gasket is provided with a first conductive coating. The first housing part during assembly is sled into engagement with the second housing part in a first sliding direction essentially parallel with the first abutment face, whereby the gasket is squeezed in a second direction essentially perpendicular to the first direction between the first abutment face and the second abutment face.

A problem with the conductive gaskets according to US 2014/0268583 is that contionues electrical contact between the first abutment face and the second abutment face may not be ensured due to manufacturing tolerances.

### SUMMARY

The problem mentioned above is solved by the gasket comprises protrusions extending in the second direction from a front side facing the second abutment face. The protrusions provide small distinct pressure zones that assist in ensuring a good electrical contact between the first and second abutment faces.

According to one or more embodiments, the second abutment face defines an angle of at less than 10 degrees with the first direction.

According to one or more embodiments, the first abutment face and the second abutment face define an angle of less than 10 degrees before assembly.

According to one or more embodiments, the first abutment face and the second abutment face define an angle of more than 5 degrees before assembly. In this case a kind "self-locking" effect can be obtained, as resulting forces due to the compression of the gasket may press the first and second housing parts against each other.

According to one or more embodiments, the abutment faces and the gasket are so embodied and dimensioned so that spring forces exerted by the gasket after assembly counteract movement of the first housing part in a direction opposite the first direction.

According to one or more embodiments, the protrusions extend less than 1 mm, preferably less than 0.5 mm from the gasket.

According to one or more embodiments, the protrusions are provided at regular intervals along the front side of gasket.

According to one or more embodiments, the gasket is made of a thermoplastic elastomer.

According to one or more embodiments, the first conductive coating is a metal painting, f. ex. copper painting.

According to one or more embodiments, the first housing part is plate shaped, and the second housing part is a container with an open side, which is essentially closed by the first housing part.

According to one or more embodiments, the first housing part comprises an inner side, which is facing the enclosure and is provided with a second conductive coating.

According to one or more embodiments, the second housing part comprises an inner side, which is facing the enclosure and is provided with a third conductive coating.

According to one or more embodiments, the first, second and third conductive coatings are made of the same material.

According to one or more embodiments, the first housing part and the second housing part are primarily made of plastics.

According to one or more embodiments, the device housing comprises and encloses electronics.

According to one or more embodiments, the outer side of the second housing part comprises an elastomeric coating.

This specification also relates to a method of manufacturing a device housing according to any of the preceding embodiments.

According to one or more embodiments, the gasket is co-molded with first housing part before assembly of the first housing part and the second housing part.

According to one or more embodiments, first housing part and the second housing part are laser welded together.

According to one or more embodiments, the first housing part is co-molded with the gasket and an outer coating made of the same material as the gasket.

The invention also relates to a method of manufacturing a device housing comprising the following steps: a) manufacturing a first housing part, b) providing a gasket on the first housing part, c) providing a first conductive coating with a first abutment face on the gasket, d) providing a second conductive coating on the first housing part, e) manufacturing a second housing part f) providing a third conductive coating with a second abutment face on the second housing part, g) sliding the first housing part into engagement with the second housing part in a first sliding direction essentially parallel with the first abutment face, whereby the gasket is squeezed in a second direction essentially perpendicular to the first direction between the first abutment face and the second abutment face.

### BRIEF DESCRIPTION OF THE FIGURES

Fig. 1 is a first perspective view of a control unit comprising a device housing according to the invention,
Fig. 2 is a second perspective view of the control unit,
Fig. 3 is a perspective view of the control unit with content and a first second housing part removed,
Fig. 4 is a first perspective view of the first housing part of the device housing,
Fig. 5 is first perspective view of a second housing part of the device housing,
Fig. 6 is a second perspective view of the first housing part,
Fig. 7 is a third view of the first housing part,
Fig. 8 is a fourth view of the first housing part,
Fig. 9 is a cross-sectional view of a part of the device housing before assembly of the first and second housing parts,
Fig. 10 is a cross-sectional view of the part the device housing shown in fig. 9 after assembly of the first and second housing parts,
Fig. 11 is a schematic cross-sectional view of parts of the first and second housing parts according to a second embodiment before assembly,
Fig. 12 is a schematic cross-sectional view of parts of the first and second housing parts according to the second embodiment after assembly,
Fig. 13 is a schematic cross-sectional view of parts of the first and second housing parts according to a third embodiment before assembly, and
Fig. 14 is a schematic cross-sectional view of parts of the first and second housing parts according to the third embodiment after assembly.

### DETAILED DESCRIPTION OF THE INVENTION

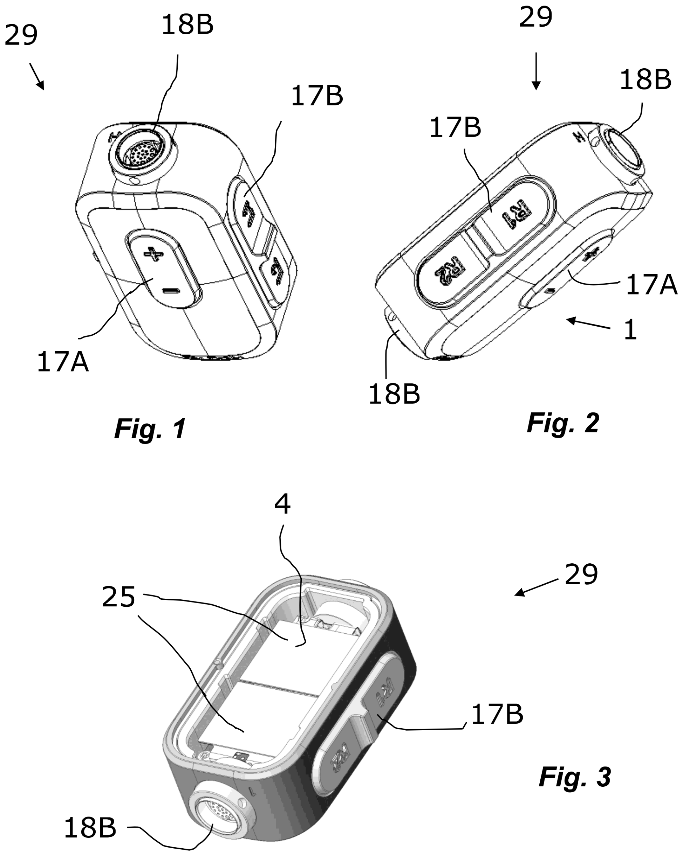

Figure 1 is a perspective view of a control unit 29 comprising a device housing 1 according to the invention. The control unit 29 is in this case a small device which can be connected to a radio unit and a headset. A first socket 18A can receive a plug of a cable connecting the control unit 29 to a headset. A Second socket 18B can receive a plug for a cable connecting the control unit 29 to a radio. A first set of buttons 17A is adapted to adjust the volume of sound in the headset. A second set of buttons 17B is adapted to select channels on the radio.

Fig. 3 shows in perspective the control unit 29 from a rear side with a first housing part 2 removed. Two flex-PCB members 25 and other electronic parts are visible.

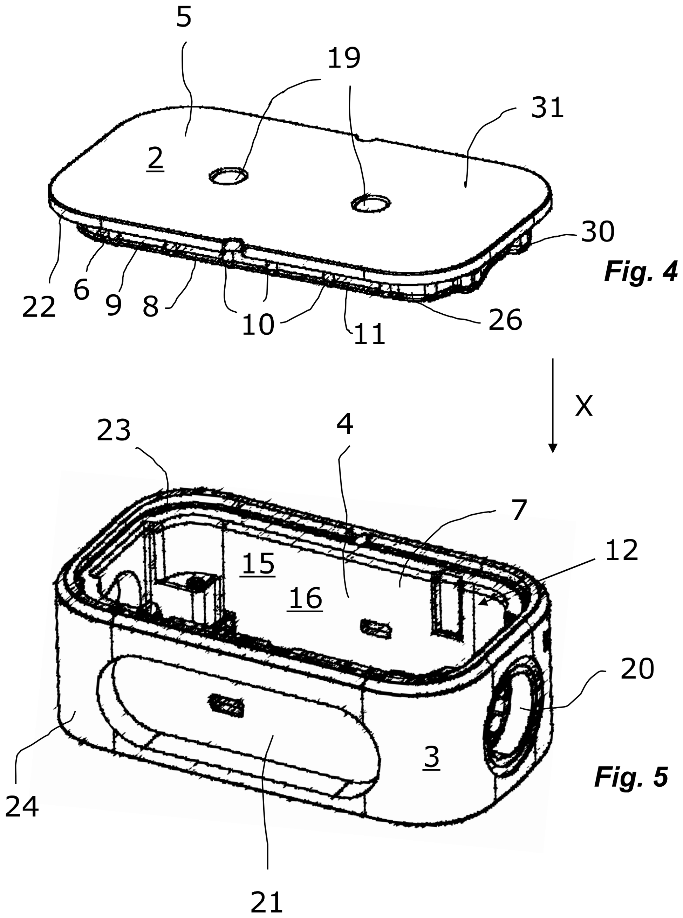

Fig. 4 is a first perspective view the enclosure of the first housing part 2 of the device housing 1 and fig. 5 is first perspective view of a second housing part 3 of the device housing 1. The first housing part 2 provides a kind of a lid which on the outer surface 5 has two screw holes 19 by means of which the housing can be attached to a Modular Lightweight Load-carrying Equipment (MOLLE) clip, that is used to attach the equipment to a Pouch Attachment Ladder System (PALS). PALS is a grid of webbing used to attach smaller equipment onto load-bearing platforms, such as vests and/or backpacks. The second housing part 3 comprises at the ends socket holes 20 for the sockets 18. The second housing part 3 comprises button recesses 21 which can receive button units providing the earlier mentioned adjustment features. The second housing part 3 provides a kind of box with an open end 12 which is to be closed by the first housing part 2. When assembling the device housing 1 the first housing part 2 is sled in the direction of the arrow X into the open side 12 of the second housing part 3 whereby the enclosure 4 will be closed on all sides.

The first and second housing parts 2, 3 are primarily made of plastic. The first housing part 2 has a main part 31 and a frame part 30 extending downwards or into the second housing part 3 in the assembled state. This frame part 30 is shaped as rib following the outer periphery of the first housing part 2. The outward facing side of this rib is the gasket side 26 as an elastic gasket 8 is attached to this. The gasket 8 has a front side 11 which provides a first abutment face 6. With regular intervals the front side is provided with protrusions 10. These protrusions 10 improves the contact between the first housing part 2 and the second housing part 3. The underside of the first housing part 2 between the outer periphery and the frame part 30 provides a first welding face 22, which will be explained later. The gasket 8 is provided with a first conductive coating 9. The underside of the first housing part facing the enclosure 4 is provided with a second conductive coating 14.

The inner wall of the second housing part 3 has an upper area which comprises a second abutment face 7, which abuts the first abutment face 6 when the first and second housing parts are assembled to the device housing 1. The outer side of the second housing part 3 is provided with an elastomeric coating 24. An upper side of the housing wall of the second housing part 3 provides a second welding face 23. The inner side 15 of the second housing part 3 is provided with a third conductive coating 16.

The first, second and third conductive coatings 9, 14 and 16 provide an efficient EMI shielding, as they together provide a conductive interconnected cage that encloses the enclosure, whereby electronics inside the device housing 1 is prevented from electromagnetic disturbance generated by an external source that affects an electrical circuit by electromagnetic induction, electrostatic coupling, or conduction. The EMI shielding also prevents the electronics inside the housing device from disturbing electrical circuits outside the device housing 1.

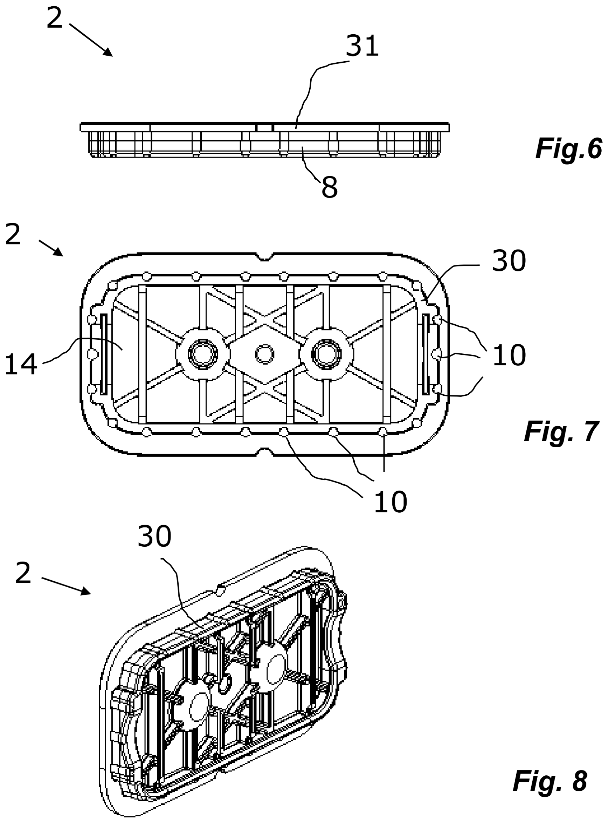

Figs. 6, 7 and 8 are second, third and fourth views of the first housing part 2. The first housing part 2 comprises the main part 31 and frame part 30. The gasket 8 is co-molded on the outwardly facing side of the frame part 30

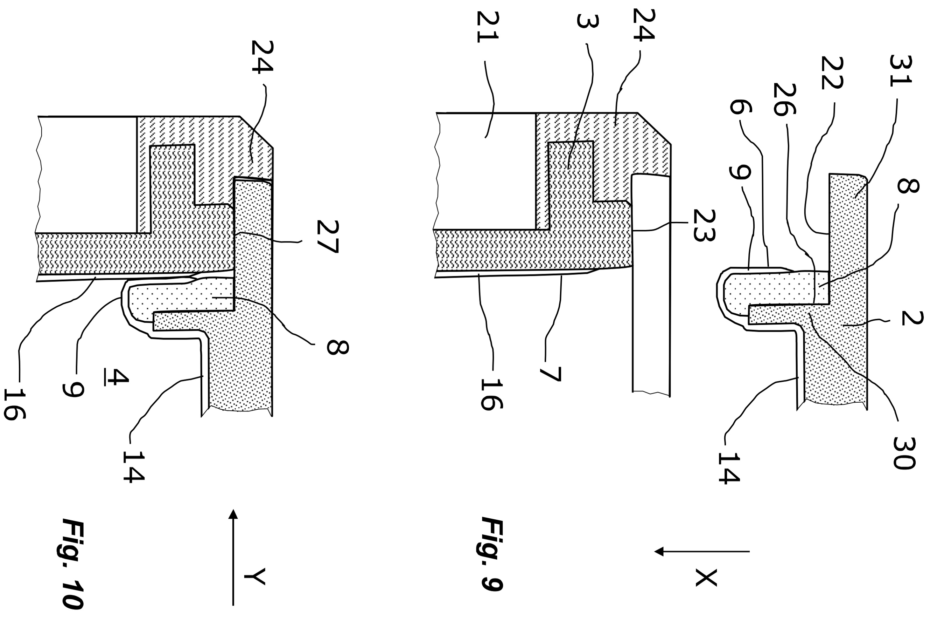

Fig. 9 is a cross-sectional view of a part of the housing before assembly of the first housing part 2 and the second housing part 3. The elastomeric gasket 8 is attached by co-molding to the frame part 30. Copper painting is provided on the gasket 8 to make a first conductive coating 9 and on the frame part 30 to make a second conductive coating 14. Copper painting on the inner side of the second housing part 3 provides a third conductive coating 16. The outer side of the second housing part 3 is provided with an elastomeric coating 24 to protect the device housing 1. During assembly of the first housing part 2 and the second housing part 3, the first housing part 2 is moved in the first direction X whereby the frame part 30 is sled into the second housing part 3.

Fig. 10 is a cross-sectional view of the part the device housing 1 shown in fig. 9 after assembly of the first housing part 2 and second housing part 3. The gasket 8 is squeezed by forces in a second direction Y essentially perpendicular to the first direction X whereby a good electrical contact between the first conductive coating 9 and the third conductive coating 16 is obtained. As it is clear from Fig. 10, the first, second and third conductive coatings 9, 14, 16 provide a continuous conductive shielding of the enclosure 4 of the device housing 1. As the forces provided by the squeezed gasket 8 are in the second direction Y, friction between the first abutment face 6 of the first conductive coating 9 and the second abutment face 7 of the third conductive coating 16 will counter work the first housing part 2 from moving out of the second housing part 3. There are essentially no forces from the squeezed gasket 8 in and against the first direction X. After assembly the first housing part 2 and the second housing part 3 are welded together by laser welding in a welding zone 27, where the first welding face 22 and the second welding face 23 touch each other. The welding zone 27 extends along the whole periphery of the first housing part 2. This welding is an extra security feature preventing disassembly of the first and second housing parts 2, 3. The first housing part 2 is made of material which is transparent to laser and at least the second welding face 23 of the second housing part 3 is made of material which absorbs the laser. The welding can provide a watertight connection between the first housing part 2 and the second housing part 3. The protrusions 10, which are not visible in Figs. 9 and 10 are integral parts of gasket 8 and increase contact pressure locally without necessarily creating areas without electrical contact. The protrusions ensure an efficient Faraday cage. The protrusions 10 may cause a risk of areas around the protrusions not providing a watertight abutment between the first abutment face 6 and the second abutment face 7. However, the laser welding zone 27 can provide the necessary watertightness between the first housing part 2 and the second housing part 3.

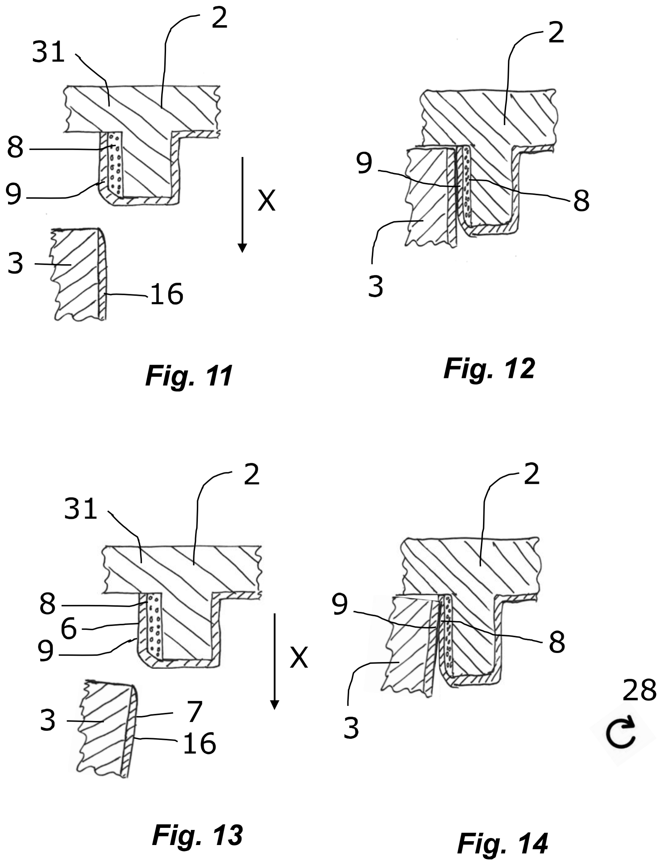

Fig. 11 is a schematic cross-sectional view of parts of the first housing part 2 and the second housing part 3 according to a second embodiment before assembly. The main difference between this embodiment and first embodiment shown in Figs. 1-10 is that the first conductive coating 9 extends all way to the underside of the main part 31 of the first housing part 2, and that the third conductive coating 16 extends all the way to the top of inner side of the second housing part 3.

Fig. 12 is a schematic cross-sectional view of parts of the first and second housing parts 2, 3 according to the second embodiment after assembly.

Fig. 13 is a schematic cross-sectional view of parts of the first and second housing parts 2, 3 according to a third embodiment before assembly. Here the second abutment surface 7 is inclined a few degrees in clockwise direction CD.

Fig. 14 is a schematic cross-sectional view of parts of the first and second housing parts 2, 3 according to the third embodiment after assembly. Forces exceeded by the squeezed gasket 8 will drag the first housing part 2 and the second housing part 3 together. The angle between the first abutment face 6 and the second abutment face 7 before assembly, which means in unstressed condition of the gasket 8, may be more than 5 degrees.

The plastic used for the first and second housing parts 2, 3 may be PC/ABS Sabic C1200HF. For the gasket 8 and the elastomeric coating 24, such as T Q8407 (TPE KRAIGURG CC60CN TAN499 master batch) or Q9271 (TPE KRAIGURG CC60CN Black master batch) may be used.

The copper paint used for the first, second and third coatings 9, 14, 16 may be PPG B-3755 Spraylat, which is applied by spraying. However other types of conductive coatings could be contemplated, such as coatings based on silver, nickel, carbon, gold or other metallic particles.

The conductive coatings could be applied by f. ex. spraying, dipping brushing, electroless plating, electroplating, vapor deposition, such as physical vapor deposition (PVD) and chemical vapor deposition (CVD), screen printing and roll coating.

The dimensions of the control unit 29 is about 64 mm x 37 mm 24 mm.

The terms "sealing" or "sealing member" could be used instead of "gasket" throughout this application.

The term "squeezed" can be replaced with the term "compressed" and vice versa through out the application.

### ITEMS

1. A device housing (1) having at least a first housing part (2) and a second housing part (3), which are adapted to be assembled to form an enclosure (4), so that a first abutment face (6) of the first housing part (2) abuts a second abutment face (7) of the second housing part (3), and wherein the first abutment face (6) is provided by an elastomeric gasket (8), which elastomeric gasket (8) is provided with a first conductive coating (9), characterized in that the first housing part (2) during assembly is sled into engagement with the second housing part (3) in a first sliding direction (X) essentially parallel with the first abutment face (6), whereby the gasket (8) is squeezed in a second direction (Y) essentially perpendicular to the first direction (X) between the first abutment face (6) and the second abutment face (7).
2. A device housing (1) according to item 1, wherein the second abutment face (7) defines an angle of at less than 10 degrees with the first direction (X).
3. A device housing (1) according to any of the preceding items, wherein the first abutment face (6) and the second abutment face (7) define an angle of less than 10 degrees before assembly.
4. A device housing (1) according to any of the preceding items, wherein the first abutment face (6) and the second abutment face (7) define an angle of more than 5 degrees before assembly.
5. A device housing (1) according to any of the preceding items, wherein the abutment faces (6, 7) and the gasket (8) are so embodied and dimensioned so that spring forces exerted by the gasket (8) after assembly counteract movement of the first housing part 2 in a direction opposite the first direction (X).
6. A device housing (1) according to any of the preceding items, wherein the gasket (8) comprises protrusions (10) extending in the second direction (Y) from a front side (11) facing the second abutment face (7).
7. A device housing (1) according to item 6, wherein the protrusions (10) extend less than 1 mm, preferably less than 0.5 mm from the gasket (8).
8. A device housing (1) according to item 6 or 7, wherein the protrusions (10) are provided at regular intervals along the front side (11) of gasket (8).
9. A device housing (1) according to any of the preceding items, wherein the gasket (8) is made of a thermoplastic elastomer.
10. A device housing (1) according to any of the preceding items, wherein the first conductive coating (9) is a metal painting, f. ex. copper painting.
11. A device housing (1) according to any of the preceding items, wherein the first housing part (2) is plate shaped, and the second housing part (3) is a container with an open side (12), which is essentially closed by the first housing part (2).
12. A device housing (1) according to any of the preceding items, wherein the first housing part (2) comprises an inner side (13), which is facing the enclosure (4) and is provided with a second conductive coating (14).
13. A device housing (1) according to any of the preceding items, wherein the second housing part (3) comprises an inner side (15), which is facing the enclosure (4) and is provided with a third conductive coating (16).
14. A device housing (1) according to item 12 and 13, wherein the first, second and third conductive coatings (9, 14, 16) are made of the same material.
15. A device housing (1) according to any of the preceding items, wherein the first housing part (2) and the second housing part (3) primarily are made of plastics.
16. A device housing (1) according to any of the preceding items, which device housing (1) comprises and encloses electronics (17).
17. A device housing (1) according to any of the preceding items, wherein the outer side of the second housing part (3) comprises an elastomeric coating (24).
18. A method of manufacturing a device housing (1) according to any of the preceding items.
19. A method of manufacturing a device housing (1) according to item 18, wherein the gasket (8) is co-molded with first housing part (2) before assembly of the first housing part (2) and the second housing part (3).
20. A method of manufacturing a device housing (1) according to any of the items 18-19, wherein the first housing part (2) and the second housing part (3) are laser welded together.
21. A method of manufacturing a device housing (1) according to any of the items 18-20, wherein the first housing part (2) is co-molded with the gasket (8) and an outer coating made of the same material as the gasket (8).
22. A method of manufacturing a device housing (1) comprising the following steps:
   a) manufacturing a first housing part (2),
   b) providing a gasket (8) on the first housing part (2),
   c) providing a first conductive coating (9) with a first abutment face (6) on the gasket (8),
   d) providing a second conductive coating (14) on the first housing part (2),
   e) manufacturing a second housing part (3),
   f) providing a third conductive coating (6) with a second abutment face (7) on the second housing part (3),
   g) sliding the first housing part (2) into engagement with the second housing part (3) in a first sliding direction (X) essentially parallel with the first abutment face (6), whereby the gasket (8) is squeezed in a second direction (Y) essentially perpendicular to the first direction (X) between the first abutment face (6) and the second abutment face (7).

### LIST OF REFERENCES

- 1: housing
- 2: first housing part
- 3: second housing part
- 4: enclosure
- 5: outer side of first housing part
- 6: first abutment face
- 7: second abutment face
- 8: gasket
- 9: first conductive coating
- 10: protrusion
- 11: front side of gasket
- 12: open side
- 13: inner side of first housing
- 14: second conductive coating
- 15: inner side of second housing part
- 16: third conductive coating
- 17: button unit
- 18: socket
- 19: screw holes
- 20: socket hole
- 21: button recess
- 22: first welding face
- 23: second welding face
- 24: elastomeric coating
- 25: flex PCB
- 26: gasket side of first housing part
- 27: welding zone
- 28: clockwise direction
- 29: control unit
- 30: frame part
- 31: main part of first housing part

## Claims

1. A device housing (1) having at least a first housing part (2) and a second housing part (3), which are adapted to be assembled to form an enclosure (4), so that a first abutment face (6) of the first housing part (2) abuts a second abutment face (7) of the second housing part (3), and wherein the first abutment face (6) is provided by an elastomeric gasket (8), which elastomeric gasket (8) is provided with a first conductive coating (9), wherein the first housing part (2) during assembly is sled into engagement with the second housing part (3) in a first sliding direction (X) essentially parallel with the first abutment face (6), whereby the gasket (8) is squeezed in a second direction (Y) essentially perpendicular to the first direction (X) between the first abutment face (6) and the second abutment face (7) **characterized in that** the gasket (8) comprises protrusions (10) extending in the second direction (Y) from a front side (11) facing the second abutment face (7).

2. A device housing (1) according to claim 1, wherein the protrusions (10) extend less than 1 mm, preferably less than 0.5 mm from the gasket (8). device housing (1) according to item 6 or 7, wherein the protrusions (10) are provided at regular intervals along the front side (11) of gasket (8).

3. A device housing (1) according to any of the preceding claims, wherein the protrusions (10) are provided at regular intervals along the front side (11) of gasket (8).

4. A device housing (1) according to any of the preceding claims, wherein the first abutment face (6) and the second abutment face (7) define an angle of more than 5 degrees before assembly.

5. A device housing (1) according to any of the preceding claims, wherein the abutment faces (6, 7) and the gasket (8) are so embodied and dimensioned so that spring forces exerted by the gasket (8) after assembly counteract movement of the first housing part 2 in a direction opposite the first direction (X).

6. A device housing (1) according to any of the preceding claims, wherein the gasket (8) is made of a thermoplastic elastomer.

7. A device housing (1) according to any of the preceding claims, wherein the first conductive coating (9) is a metal painting, f. ex. copper painting.

8. A device housing (1) according to any of the preceding items, wherein the first housing part (2) is plate shaped, and the second housing part (3) is a container with an open side (12), which is essentially closed by the first housing part (2).

9. A device housing (1) according to any of the preceding items, wherein the first housing part (2) comprises an inner side (13), which is facing the enclosure (4) and is provided with a second conductive coating (14).

10. A device housing (1) according to any of the preceding items, wherein the second housing part (3) comprises an inner side (15), which is facing the enclosure (4) and is provided with a third conductive coating (16).

11. A method of manufacturing a device housing (1) according to any of the preceding claims.

12. A method of manufacturing a device housing (1) according to claim 11, wherein the gasket (8) is co-molded with first housing part (2) before assembly of the first housing part (2) and the second housing part (3).

13. A method of manufacturing a device housing (1) according to any of the claims 11-12, wherein the first housing part (2) and the second housing part (3) are laser welded together.

14. A method of manufacturing a device housing (1) according to any of the claims 11-13, wherein the first housing part (2) is co-molded with the gasket (8) and an outer coating made of the same material as the gasket (8).

15. A method of manufacturing a device housing (1) comprising the following steps:
a) manufacturing a first housing part (2),
b) providing a gasket (8) on the first housing part (2), which gasket (8) comprises protrusions (10) extending in a second direction (Y) from a front side (11) facing the second abutment face (7).
c) providing a first conductive coating (9) with a first abutment face (6) on the gasket (8),
d) providing a second conductive coating (14) on the first housing part (2),
e) manufacturing a second housing part (3),
f) providing a third conductive coating (16) with a second abutment face (7) on the second housing part (3),
g) sliding the first housing part (2) into engagement with the second housing part (3) in a first sliding direction (X) essentially parallel with the first abutment face (6), whereby the gasket (8) is squeezed in the second direction (Y) essentially perpendicular to the first direction (X) between the first abutment face (6) and the second abutment face (7).
